# EUROPÄISCHE PATENTANMELDUNG

(11) **EP 0 828 333 A2**
(43) Veröffentlichungstag der Anmeldung: **11.03.1998**
(21) Anmeldenummer: 97810544.3
(22) Anmeldetag: 29.07.1997
(51) Int. Cl.: H02H 9/02

(54) **Verfahren zur Herstellung eines Strombegrenzers mit einem Hochtemperatur-Supraleiter und Strombegrenzer**

(30) Priorität: 26.08.1996 DE 19634424
(71) Anmelder: ABB RESEARCH LTD., 8050 Zürich (CH)
(72) Erfinder: Chen, Makan, 5404 Baden-Dättwil (CH); Hoidis, Markus, 5408 Ennetbaden (CH); Paul, Willi, Dr., 5430 Wettingen (CH)
(74) Vertreter: Rzehak, Herbert

(57) **Zusammenfassung**

Strombegrenzer mit einem Hochtemperatursupraleiter (3) erhöhen beim Übergang vom supraleitenden in den normalleitenden Zustand ihren elektrischen Widerstand und begrenzen somit einen elektrischen Strom, der sie durchfließt. Zur elektrischen Stabilisierung steht der Hochtemperatursupraleiter (3) in einem gutleitenden, flächenhaften Leiterverbund mit einer Silberfolie (1) mit einer Schichtdicke von < 50 µm. Das Verhältnis der Schichtdicke des Hochtemperatursupraleiters (3) zu derjenigen der Silberfolie (1) soll < 1/10 sein. Zur Herstellung dieses Leiterverbundes (1, 3) wird die Silberfolie (1) einerseits auf eine 2 mm dicke Pulverschicht aus MgO gelegt und andererseits mit einer 600 µm dicken sog. Grünfolie überdeckt, welche ein Hochtemperatursupraleiterpulver und einen organischen Binder enthält. Nach dem Erschmelzen des Hochtemperatursupraleiters wird zu dessen mechanischen Stabilisierung auf mindestens eine Seite des Leiterverbundes (1, 3) durch Vakuumimprägnieren eine 200 µm dicke Glas- oder Kohlefaser-Epoxidharzschicht aufgebracht. Zur Herstellung resistiver Strombegrenzer werden plattenförmige Strombegrenzerelemente mit dem angegebenen Schichtaufbau mäanderförmig ausgeschnitten und in mindestens 2 Schichten übereinander verklebt oder verpreßt, ggf. unter Zwischenschaltung von Kühlelementen. Durch rohrförmiges Biegen derartiger flexibler Platten und Verlöten eines Ringspaltes (9) mit einem Metallstreifen (5) aus Silber erhält man induktive Strombegrenzer.

## Beschreibung

### TECHNISCHES GEBIET

Bei der Erfindung wird ausgegangen von einem Verfahren zur Herstellung eines Strombegrenzers mit einem Hochtemperatursupraleiter und von einem Strombegrenzer nach dem Oberbegriff der Patentansprüche 1 und 6.

### STAND DER TECHNIK

Mit dem Oberbegriff der Patentansprüche 1 und 6 nimmt die Erfindung auf einen Stand der Technik Bezug, wie er aus der EP 0 592 797 A2 bekannt ist. Dort ist ein Verfahren zur Herstellung eines kreiszylindrischen Hochtemperatursupraleiters hoher Stromtragfähigkeit für Abschirmzwecke und für induktive Strombegrenzer angegeben, bei der das in die Schmelzform eingesetzte Silber, bei einer Verwendung als magnetische Abschirmung, als gutleitender Bypaß zum Hochtemperatursupraleiter wirkt. Dabei wird u. a. Bi₂Sr₂CaCu₂O₈-Pulver entweder trocken oder als Suspension, bestehend aus Pulver, organischem Lösungsmittel und Binder, bei Zimmertemperatur über eine Förderrinne in die Schmelzform eingebracht. Nach einem Ausbrennen des Binders bei 500 °C ± 50 K erfolgt ein partielles Schmelzen des Hochtemperatursupraleiter-Pulvers mit nachfolgendem Abkühlen und bis zu 3maligem Langzeitglühen in Sauerstoffatmosphäre. Dabei werden selbsttragende supraleitende Zylinder mit einer Wandstärke von 2,5 mm aus der 200 µm dicken Silberform geschält, während supraleitende Zylinder mit einer Wandstärke von 50 µm nicht von einer 50 µm dicken Silberschicht, welche sich auf einer 1 mm dicken Ni-Cr- oder Fe-Ni-Legierung befindet, als Unterlage getrennt werden. Diese silberbeschichtete Ni-Cr- oder Fe-Ni-Schicht wirkt dann in Strombegrenzern als mechanische und elektrische Stütze.

Nachteilig dabei ist, daß eine Silberform von 200 µm Dicke für Hochtemperatursupraleiter relativ teuer ist. Silberbeschichtete Ni-Cr- oder Fe-Ni-Schichten sind in ihrer Herstellung aufwendig. Andererseits löst der heiße Hochtemperatursupraleiter aus dünnen Silberschichten (< 100 µm) feine Löcher heraus. Flüssiger Hochtemperatursupraleiter tritt durch diese Löcher aus und reagiert mit der Unterlage der Silberschicht, so daß der Hochtemperatursupraleiter kontaminiert wird.

Aus der DE 4 434 819 C1 ist ein Strombegrenzer bekannt, der beiderseits eines scheibenförmigen Isolators von 1 mm Dicke aus glasfaserverstärktem Gießharz oder aus einer MgO-Keramikplatte je einen Leiterverbund aus einem Hochtemperatursupraleiter und einem Normalleiter aus einem bei Zimmertemperatur duktilen Metall oder einer Metallegierung aufweist. Zwischen diesen Leiterverbunden und dem Isolator ist eine chemisch isolierende Pufferschicht aus 1 µm - 5 µm dickem Silber angeordnet. Jeder Leiterverbund ist mäanderförmig ausgebildet und so miteinander verbunden, daß ein Strom in direkt einander gegenüberliegenden Teilbändern der Leiterverbunde antiparallel fließt, so daß sich die zur Bandebene senkrechten Komponenten des Eigenmagnetfeldes kompensieren und die Strombegrenzermodule niederinduktiv und verlustarm sind. Der flächenbezogene, spezifische Kontaktwiderstand zwischen einer Hauptfläche des Hochtemperatursupraleiters und des Normalleiters ist < 1mΩ cm², vorzugsweise ≤ 10 µΩ cm². Für den Fall, daß die Supraleiterplatten in einer Silberform aus einem 100 µm dicken Silberblech geschmolzen wurden, welches nach dem Schmelzen entfernt wird, wird der scheibenförmige Isolator mit einem Klebstoff auf die Silber-Pufferschicht aufgebracht.

Für Anwendungen zur Strombegrenzung muß das Silbersubstrat wegen seines zu geringen elektrischen Widerstandes entfernt werden. Zur elektrischen Stabilisierung wird der Hochtemperatursupraleiter anschließend wieder mit einem elektrischen Normalleiter höheren Widerstandes beschichtet. Dieser Herstellungsprozeß ist relativ aufwendig und wegen der benötigten Silbermengen recht teuer.

Schmelzsubstrate auf einer Nickelbasislegierung mit einer dünnen Schutzbeschichtung aus Silber oder aus MgO-Keramik brauchen nach der Herstellung des Hochtemperatursupraleiters nicht entfernt zu werden; sie dienen diesem als mechanische Stabilisierung. Die Dicke des Normalleiters liegt im Bereich von 10 µm - 50 µm, diejenige des Hochtemperatursupraleiters im Bereich von 0,3 mm - 3 mm.

Für Strombegrenzer ist es wünschenswert, möglichst dünnwandige supraleitende Hohlzylinder oder Platten herstellen zu können, um ihre Wechselstromverluste möglichst gering zu halten. Gleichzeitig braucht der Supraleiter eine elektrische Stabilisierung, deren Widerstand nicht zu niedrig, aber auch nicht zu hoch ist.

Die einzigen Substrate, welche nicht zu einer Reduktion der supraleitenden Eigenschaften des Hochtemperatursupraleiters führen, sind Silber, Gold und MgO. Eine Ag/Au-Legierung mit 5 % Au hätte zwar einen höheren Widerstand als reines Silber, es wäre aber viel teurer als Silber. MgO-Substrate können nicht direkt als elektrische Stabilisierung verwendet werden, außerdem sind MgO-Teile der benötigten Qualität teurer als reines Silber. Eine Reduktion der Schichtdicke der als Substrat dienenden Silberfolie würde sowohl die Kosten des Substrates verringern, als auch seinen elektrischen Widerstand erhöhen, so daß sie direkt als elektrische Stabilisierung verwendet werden könnte.

### DARSTELLUNG DER ERFINDUNG

Die Erfindung, wie sie in den Patentansprüchen 1 und 6 definiert ist, löst die Aufgabe, ein Verfahren zur Herstellung eines Strombegrenzers mit einem Hochtemperatursupraleiter und einen Strombegrenzer der eingangs genannten Art derart weiterzuentwickeln, daß dessen Herstellung einfacher und billiger wird.

Vorteilhafte Ausgestaltungen der Erfindung sind in den abhängigen Patentansprüchen definiert.

Ein Vorteil der Erfindung besteht darin, daß die zum Schmelzen des Hochtemperatursupraleiters verwendete Silberfolie nur etwa 20 µm dick sein muß. Der Hochtemperatursupraleiter wird nicht kontaminiert und verklebt auch nicht mit der Unterlage der Silberfolie. Die Silberfolie kann anschließend als elektrische Stabilisierung am Supraleiter verbleiben.

Gemäß einer vorteilhaften Ausgestaltung der Erfindung können relativ flexible Platten zu Rohren gebogen und an den Nahtstellen elektrisch miteinander verbunden werden.

### KURZE BESCHREIBUNG DER ZEICHNUNGEN

Die Erfindung wird nachstehend anhand von Ausführungsbeispielen erläutert. Es zeigen:
- Fig. 1 und 2: 2 mäanderförmige Strombegrenzerelemente in perspektivischer Ansicht und unterschiedlicher Anordnung,
- Fig. 3: ein Schnittansicht in Schnittrichtung A - A von Fig. 1, zusätzlich mit einer mechanischen Stabilisierungsschicht, in welche die Strombegrenzerelemente eingebettet sind,
- Fig. 4: eine zu Fig. 3 alternative Einbettung der Strombegrenzerelemente,
- Fig. 5: eine Schnittansicht durch einen mäanderförmigen Strombegrenzer mit mehreren Strombegrenzerelementen und zwischengelagerten Kühlelementen,
- Fig. 6: eine Schnittansicht eines Schichtenaufbaues zur Herstellung eines Leiterverbundes,
- Fig. 7: eine Schnittansicht durch einen Leiterverbund mit mechanischen Stabilisierungsschichten und
- Fig. 8: ein rohrförmiges Strombegrenzerelement im Querschnitt.

### WEGE ZUR AUSFUHRUNG DER ERFINDUNG

In den Figuren sind gleiche Teile mit gleichen Bezugszeichen gekennzeichnet.

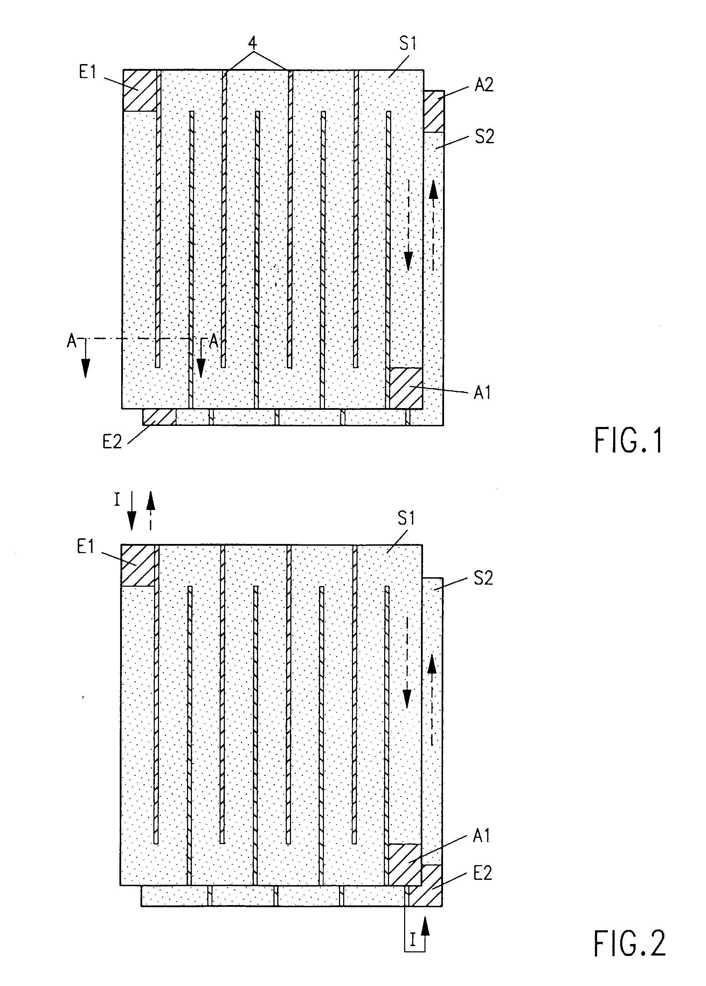

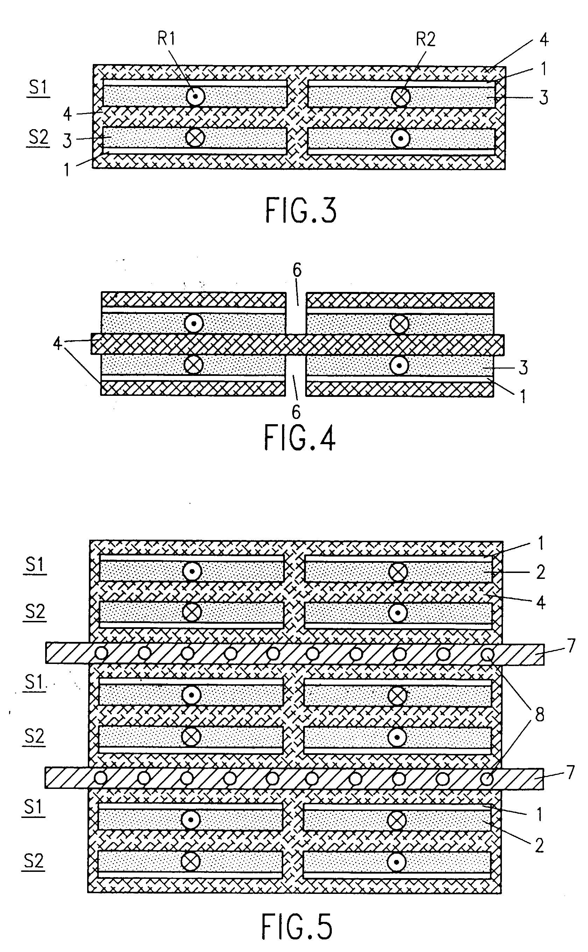

Fig. 1 zeigt eine perspektivische Ansicht 2er gleich aufgebauter, mäanderförmiger Strombegrenzerelemente (S1, S2) mit Stromeingangskontakten (E1) bzw. (E2) aus Silber und Stromausgangskontakten (A1) bzw. (A2) ebenfalls aus Silber. Die Strombegrenzerelemente (S1, S2) sind in geringem Abstand hintereinander derart angeordnet und in eine mechanische Stabilisierungsschicht (4) aus einem faserverstärkten Kunststoff, vorzugsweise aus einem Kohlefaser- oder Glasfaser-Epoxidharzverbund, eingebettet, wie es aus einer Querschnittsansicht in Fig. 3 ersichtlich ist, längs einer Schnittlinie A - A mit Blick in Richtung der beiden Pfeile in Fig. 1. Ein in den Stromeingangskontakt (E1) bzw. (E2) in das Strombegrenzerelement (S1) bzw. (S2) eintretender und aus dem Stromausgangskontakt (A1) bzw. (A2) austretender Strom fließt in einer 1. Mäanderbahn des Strombegrenzerelementes (S1) in einer 1. Stromflußrichtung (R1), welche in Fig. 3 durch einen Punkt in einem Kreis angedeutet ist. In der benachbarten Mäanderbahn desselben Strombegrenzerelementes (S1) sowie in der unterhalb dieser 1. Mäanderbahn liegenden 1. Mäanderbahn des Strombegrenzerelementes (S2) fließt der Strom in einer zur 1. Stromflußrichtung (R1) entgegengesetzten 2. Stromflußrichtung (R2), welche in Fig. 3 durch ein x in einem Kreis angedeutet ist. Diese Anordnung eignet sich für eine elektrische Parallelschaltung der beiden Strombegrenzerelemente (S1, S2).

Fig. 3 zeigt im oberen Teil 2 nebeneinanderliegende Bahnen des 1. Strombegrenzerelementes (S1) und darunter 2 nebeneinanderliegende Bahnen des 2. Strombegrenzerelementes (S2), die ganz in die mechanische Stabilisierungsschicht (4) eingebettet sind. Die Strombegrenzerelemente (S1, S2) enthalten Leiterverbunde aus einem Normalleiter bzw. aus einer Silberfolie (1) und einem Hochtemperatursupraleiter (3).

Die Strombegrenzerelemente (S1, S2) können auch so zusammengefügt und in die mechanische Stabilisierungsschicht (4) eingebettet sein, wie es aus Fig. 4 ersichtlich ist. Dabei sind Mäanderausnehmungen (6) nicht nur zwischen benachbarten Bahnen der Leiterverbunde derselben Strombegrenzerelemente (S1, S2) vorgesehen, sondern auch in deren mechanischer Stabilisierungsschicht (4).

Fig. 2 zeigt perspektivisch 2 Strombegrenzerelemente (S1, S2), wobei das 1. Strombegrenzerelement (S1) wie in Fig. 1 angeordnet, das 2. Strombegrenzerelement (S2) jedoch um 180° gegenüber dem in Fig. 1 dargestellten gedreht ist. Diese Anordnung eignet sich für eine elektrische Reihenschaltung der beiden Strombegrenzerelemente (S1, S2), wobei der Stromausgangskontakt (A1) des Strombegrenzerelementes (S1) mit dem Stromeingangskontakt (E2) des Strombegrenzerelementes (S2) elektrisch verbunden wird. Die Pfeile zeigen die Flußrichtung eines Stromes (I) an. Auch hier fließt der Strom (I) in seitlich benachbarten sowie in übereinanderliegenden Mäanderbahnen in zueinander entgegengesetzten 1. und 2. Stromflußrichtungen (R1) bzw. (R2).

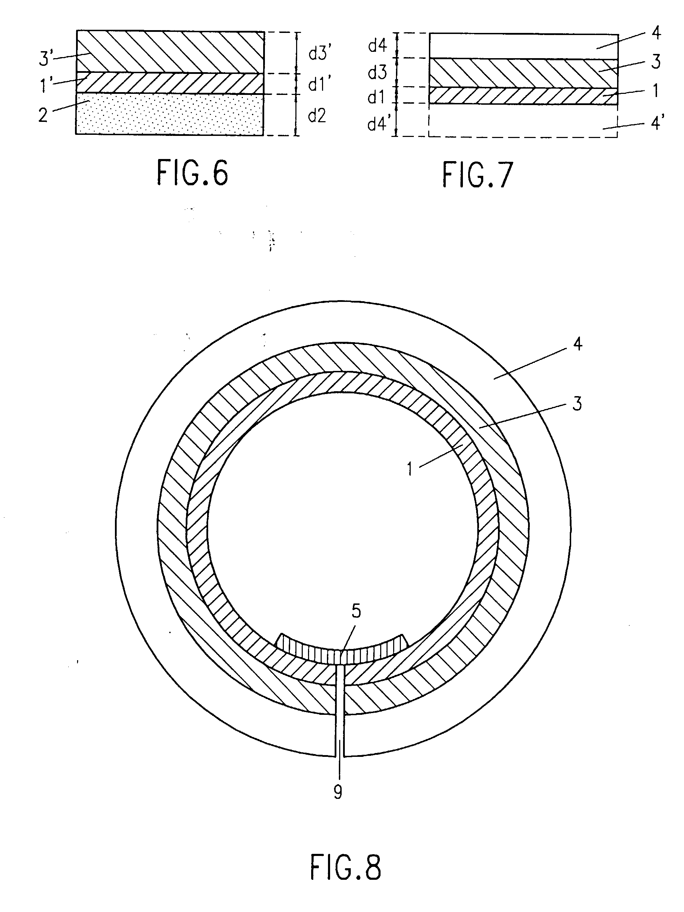

Fig. 5 zeigt 6 in eine mechanische Stabilisierungsschicht (4) eingebettete Strombegrenzerelemente (S1, S2), von denen je 2 Doppelmäanderbahnen gemäß Fig. 1 bilden. Diese Doppelmäanderbahnen sind mit einem faserverstärkten Kunststoff (4) übereinander zu einem Stapel verpreßt oder verklebt, wobei zwischen ihnen Kühlelemente (7) mit Kühlkanälen (8) für ein Kühlfluid, vorzugsweise flüssigen Stickstoff, angeordnet sind. Als Kühlelemente (7) eignen sich Metall- oder Keramikplatten.

Fig. 6 zeigt auszugsweise einen nicht maßstabsgerechten Schichtaufbau für die Herstellung eines Leiterverbundes aus Silberfolie (1) und dem Hochtemperatursupraleiter (3).

Auf eine Inertpulverschicht (2) mit einer Schichtdicke (d2) von vorzugsweise 2 mm aus einem Material, das gegenüber dem Hochtemperatursupraleiter (3) in seinem heißen Zustand chemisch inert ist, wird eine Silberfolie (1') mit einer Schichtdicke (d1') von vorzugsweise 20 µm aufgebracht. Für diese Inertpulverschicht (2) eignet sich besonders Magnesiumoxid, MgO. Zusätzlich oder anstelle von MgO können auch Pulver aus Ce₂O₃, SrZrO₃, SrSO₄, Y₂O₃ und ZrO₂ verwendet werden. Auf die Silberfolie (1') wird eine sog. Grünfolie (3') mit einer Schichtdicke (d3') von vorzugsweise 600 µm aufgeschmolzen, die oxidkeramisches Pulver für den Hochtemperatursupraleiter (3) sowie einen organischen Binder enthält. Vorzugsweise wird ein Hochtemperatursupraleiter (3) mit einer Bi-Verbindung, vorzugsweise mit einer Bi2212-Verbindung der Zusammensetzung Bi₂Sr₂Ca₁Cu₂Oₓ hergestellt, mit 7 ≤ x ≤ 9. Das pulverförmige Ausgangsmaterial für den Hochtemperatursupraleiter sollte in der Grünfolie (3') einen Volumenanteil im Bereich von 20 % - 60 % aufweisen. Vorzugsweise sollte dem pulverförmigen Ausgangsmaterial (3') Silberpulver mit einem Volumenanteil im Bereich von 1 % - 30 % beigemischt sein. Die Temperatur- und Sauerstoffbehandlung zur Herstellung des o. g. Leiterverbundes ist in der eingangs genannten EP 0 592 797 A2 beschrieben.

Im Ergebnis der Supraleiter-Herstellung entsteht ein Leiterverbund mit einer Silberfolie (1) mit einer Schichtdicke (d1) mit einem Hochtemperatursupraleiter (3) einer Schichtdicke (d3), wie er aus Fig. 7 erkennbar ist. Während des Schmelzprozesses reduziert sich die Dicke der Grünfolie (3') auf etwa 200 µm. Gleichzeitig lösen sich etwa 5 % Ag im flüssigen Hochtemperatursupraleiter (3), so daß die Schichtdicke (d1') der Silberfolie (1) auf 10 µm (d1) reduziert wird. Dabei wird die Silberfolie (1') punktweise von der Schmelze des Hochtemperatursupraleiters (3) aufgelöst. Die Inertpulverschicht (2) verhindert ein Ausfließen des Hochtemperatursupraleiters (3), eine Reduktion der supraleitenden Eigenschaften des Hochtemperatursupraleiters (3) sowie ein Verkleben mit der nicht dargestellten Unterlage der Inertpulverschicht (2). Der Kontaktwiderstand zwischen dem Hochtemperatursupraleiter (3) und der Silberfolie (1) ist kleiner als 1 µΩ cm². Der Hochtemperatursupraleiter (3) enthält einen Silberanteil im Bereich von 3 % - 30 %.

Zur mechanischen Stabilisierung wird dieser Leiterverbund (1, 3) auf mindestens einer Seite bzw. Hauptfläche mit einer mechanischen Stabilisierungsschicht (4) mit einer Schichtdicke (d4) von vorzugsweise 200 µm aus einem Faserkunststoff durch Vakuumimprägnieren aufgebracht. In dieser Form können die so hergestellten Platten bereits eine Anwendung als elektromagnetische Abschirmung finden. Zusätzlich zur mechanischen Stabilisierungsschicht (4) kann auf einer 2. Hauptfläche des Leiterverbundes (1, 3) eine 2. gestrichelt dargestellte mechanische Stabilisierungsschicht (4') mit einer Schichtdicke (d4') aufgebracht sein, die etwa gleich der Schichtdicke (d4) ist.

Die relativ flexiblen Platten aus einem Leiterverbund (1, 3) und einer mechanischen Stabilisierungsschicht (4) können zu Rohren gebogen und an den Nahtstellen bzw. an einem Ringspalt (9) mit einem Metallstreifen (5) aus einem gutleitenden Metall, vorzugsweise aus Silber oder Kupfer, elektrisch miteinander verbunden werden. Ein derartiges Rohr ist im Querschnitt in Fig. 8 dargestellt. Der Metallstreifen (5) kann z. B. 4 cm breit, 200 µm dick und mit der Silberfolie (1) verlötet sein. In dieser Ausführung eignet sich das Strombegrenzerelement gemäß Fig. 8 zur induktiven Strombegrenzung.

Zur resistiven Strombegrenzung werden 2 Strombegrenzerelemente (S1, S2) oder ein Vielfaches davon miteinander verklebt oder verpreßt und ggf. mäanderförmig strukturiert, wie es aus Fig. 5 ersichtlich ist. Zur Minimierung der Wechselstromverluste werden diese Platten elektrisch so verbunden, daß der Strom (I) in 2 benachbarten Platten jeweils antiparallel fließt.

Indem man dem Hochtemperatursupraleiterpulver (3') bereits vor dem partiellen Schmelzen Silber beimischt, kann man die Reduktion der Silberfolie (1') vorgeben oder völlig unterbinden. In jedem Fall werden jedoch in der dünnen Silberfolie (1) feine Löcher auftreten, da bei der Erstarrung des Hochtemperatursupraleiters (3) bis zu 30 µm lange Hochtemperatursupraleiter-Nadeln (nicht dargestellt) in das Silber hineinwachsen.

### Ausführungsbeispiel 1:

Mittels eines Foliengießverfahrens wurde eine 600 µm dicke Grünfolie (3') mit einem Hochtemperatursupraleiterpulver der Zusammensetzung Bi₂Sr₂Ca₁Cu₂Oₓ hergestellt. Diese Grünfolie (3') wurde mit einer Breite von 10 cm und einer Länge von 120 cm auf eine 20 µm dicke Silberfolie (1) aufgebracht, welche auf MgO-Pulver (2) gebettet war. Nach dem Ausbrennen des in der Grünfolie (3') enthaltenen Binders wurde der Hochtemperatursupraleiter (3) partiell aufgeschmolzen. Nach dem Erstarren betrug die Schichtdicke (d3) des Hochtemperatursupraleiters (3) etwa 200 µm und die Schichtdicke (dl) der Silberfolie (1) etwa 10 µm. Der Kontaktwiderstand zwischen Hochtemperatursupraleiter (3) und Silberfolie (1) war kleiner als 1 µΩ cm². Die kritische Stromdichte des Hochtemperatursupraleiters (3) betrug 3 kA/cm².

Der Leiterverbund (1, 3) wurde anschließend auf der Seite des Hochtemperatursupraleiters (3) mit einem 200 µm dicken Glasfaser-Epoxidharzverbund mechanisch verstärkt. Das so erhaltene relativ flexible Band mit den Abmessungen 400 µm x 60 cm x 10 cm wurde anschließend zu einem Ring mit einem Durchmesser von 8 cm geformt. Die Enden des Bandes wurden mittels eines 200 µm dicken und 4 cm breiten normalleitenden Ag- oder Cu-Streifens (5) durch Verlöten elektrisch verbunden und anschließend mit einer weiteren beidseitigen Lage aus Glasfaser-Epoxidharzverbund (4, 4') mechanisch verstärkt.

Der so erhaltene Ring hatte eine Stromtragfähigkeit von 800 A. Der geringe elektrische Widerstand von etwa 3 µΩ, welchen der Ring auch im supraleitenden Zustand zeigte, störte den Betrieb im induktiven Strombegrenzer nicht. Um einen höheren Gesamtstrom zu erhalten, können mehrere Ringe ineinandergeschachtelt werden.

### Ausführungsbeispiel 2:

Mittels eines Foliengießverfahrens wurde eine 1,2 mm dicke Grünfolie (3') mit einem Hochtemperatursupraleiterpulver der Zusammensetzung Bi₂Sr₂Ca₁Cu₂Oₓ und 5 % Silberbeimengung hergestellt. Die 20 cm x 20 cm breite Folie wurde mäanderförmig strukturiert, mit einer Stegbreite von 1 cm, und auf eine 20 µm dicke Silberfolie (1) aufgebracht, welche auf MgO-Pulver (2) gebettet war. Nach dem Ausbrennen des Binders wurde der Hochtemperatursupraleiter (3) partiell aufgeschmolzen. Nach dem Erstarren betrug die Schichtdicke (d3) des Hochtemperatursupraleiters (3) etwa 400 µm und die Schichtdicke (d1) der Silberfolie (1) noch immer etwa 20 µm, wegen der Silberbeimischung zur Grünfolie (3'). Der Kontaktwiderstand zwischen Hochtemperatursupraleiter (3) und Silberfolie (1) war kleiner als 1 µΩ cm². Die kritische Stromdichte des Hochtemperatursupraleiters (3) betrug 2 kA/cm² und die Stromtragfähigkeit des Mäanders 80 A.

Der Mäander wurde auf der Seite des Hochtemperatursupraleiters (3) mit einem 300 µm dicken Kohlefaser-Epoxidharzverbund verstärkt. Anschließend wurde die in den Mäanderausnehmungen (6) noch verbliebene Silberfolie (1) entfernt. Zwei der so erhaltenen Mäander gemäß Fig. 2 wurden dann derart miteinander verklebt und an einem Ende elektrisch verbunden, daß ein durch die Mäander fließender Strom (I) in gegenüberliegenden Mäanderstreifen in zueinander entgegengesetzter Stromflußrichtung (R1, R2) floß. Dieser Strombegrenzer dient zu einer resistiven Strombegrenzung.

### Ausführungsbeispiel 3:

Mittels eines Foliengießverfahrens wurde eine 300 µm dicke Grünfolie (3') mit einem Hochtemperatursupraleiterpulver der Zusammensetzung Bi₂Sr₂Ca₁Cu₂Oₓ hergestellt. Die 20 cm x 20 cm breite Folie wurde auf eine 25 µm dicke Silberfolie (1) aufgebracht, welche auf MgO-Pulver (2) gebettet war. Nach dem Ausbrennen des Binders wurde der Hochtemperatursupraleiter (3) partiell aufgeschmolzen. Nach dem Erstarren betrug die Schichtdicke (d3) des Hochtemperatursupraleiters (3) etwa 100 µm und die Schichtdicke (d1) der Silberfolie (1) etwa 20 µm. Der Kontaktwiderstand zwischen Hochtemperatursupraleiter (3) und Silberfolie (1) war kleiner als 1 µΩ cm². Die kritische Stromdichte des Hochtemperatursupraleiters (3) betrug 8 kA/cm².

Der Leiterverbund (1, 3) wurde anschließend auf beiden Hauptflächen mit einem 200 µm dicken Glasfaserepoxidharz mechanisch verstärkt. 2 derartige Platten wurden miteinander verklebt und anschließend mäanderförmig strukturiert. 3 dieser Doppelmäander wurden mit 2 Kühlelementen (7) aus Aluminium verklebt, gemäß Fig. 5. Die Kühlelemente (7) dienen zur Kühlung sowie zur mechanischen Stabilisierung des resistiven Strombegrenzers.

Wichtig ist, daß der Hochtemperatursupraleiter (3) eine Schichtdicke d3 von < 500 µm aufweist, daß die Silberschicht (1) eine Schichtdicke d1 von < 25 µm aufweist und daß d1/d3 < 1/5 ist. Vorzugsweise sollte d3 < 300 µm, d1 < 10 µm und d1/d3 < 1/10 sein. Die mechanische Stabilisierungsschicht (4, 4') sollte eine Schichtdicke (d4, d4') im Bereich von 50 µm - 1 mm aufweisen und einen faserverstärkten Kunststoff aus glas- oder kohlefaserverstärktem Epoxidharz enthalten.

### BEZEICHNUNGSLISTE

- 1, 1': Normalleiter, Silberfolie
- 2: Inertpulverschicht
- 3: Hochtemperatursupraleiter
- 3': Grünfolie, pulverförmiges Ausgangsmaterial mit organischem Binder zur Herstellung von 3
- 4: mechanische Stabilisierungsschicht, faserverstärkter Kunststoff, Kohlefaser-Epoxidharzverbund, Glasfaser-Epoxidharzverbund
- 5: Metallstreifen, Silber- oder Kupferstreifen
- 6: Mäanderausnehmung
- 7: Kühlelement, Metall- oder Keramikplatte
- 8: Kühlkanäle
- 9: Ringspalt

- A - A: Schnittlinie in Fig. 1
- A1, A2: Stromausgangskontakte von S1, S2
- d1 - d4': Schichtdicken von 1 - 4'
- E1, E2: Stromeingangskontakte von S1 bzw. S2
- I: Strom
- R1, R2: zueinander entgegengesetzte Stromflußrichtungen
- S1, S2: Strombegrenzerelemente

## Patentansprüche

1. Verfahren zur Herstellung eines Strombegrenzers mit einem Hochtemperatursupraleiter (3),
a) wobei auf einer ersten Hauptfläche einer Silberschicht (1')
b) ein pulverförmiges Ausgangsmaterial (3') für einen Hochtemperatursupraleiter aufgebracht und
c) danach durch eine Temperatur- und Sauerstoffbehandlung ein Hochtemperatursupraleiter (3) hergestellt wird, welcher mit der Silberschicht (1) einen Leiterverbund bildet,
dadurch gekennzeichnet,
d) daß vor dem Aufbringen des pulverförmigen Ausgangsmaterials (3') für den Hochtemperatursupraleiter auf die erste Hauptfläche dieser Silberschicht (1') eine der ersten Hauptfläche gegenüberliegende zweite Hauptfläche dieser Silberschicht (1') auf eine Inertpulverschicht (2) gelegt wird, welche gegenüber dem Hochtemperatursupraleiter in seinem heißen Zustand chemisch inert ist, und
e) daß nach der Herstellung des Hochtemperatursupraleiters (3) auf mindestens eine Hauptfläche des Leiterverbundes (1, 3) eine mechanische Stabilisierungsschicht (4, 4') aufgebracht wird.

2. Verfahren nach Anspruch 1, dadurch gekennzeichnet, daß das pulverförmige Ausgangsmaterial für einen Hochtemperatursupraleiter in eine Grünfolie (3') mit einem organischen Binder eingebracht wird und darin einen Volumenanteil im Bereich von 20 % - 60 % aufweist.

3. Verfahren nach Anspruch 1 oder 2, dadurch gekennzeichnet, daß dem pulverförmigen Ausgangsmaterial (3') für einen Hochtemperatursupraleiter Silberpulver mit einem Volumenanteil im Bereich von 1 % - 30 % beigemischt wird.

4. Verfahren nach einem der vorhergehenden Ansprüche, dadurch gekennzeichnet,
a) der Hochtemperatursupraleiter (3) eine Bi-Verbindung enthält und
b) daß die Inertpulverschicht (2) MgO und/oder Ce₂O₃ und/oder SrZrO₃ und/oder SrSO₄ und/oder Y₂O₃ und/oder ZrO₂ enthält,
c) insbesondere, daß der Hochtemperatursupraleiter (3) eine Bi2212-Verbindung enthält.

5. Verfahren nach einem der vorhergehenden Ansprüche, dadurch gekennzeichnet, daß die mindestens eine mechanische Stabilisierungsschicht (4, 4') durch Vakuumimprägnieren aufgebracht wird.

6. Strombegrenzer
a) mit mindestens einem Hochtemperatursupraleiter (3) und
b) mit mindestens einem nichtsupraleitenden Nebenschlußwiderstand aus einer Silberschicht (1) parallel zum Hochtemperatursupraleiter (3),
c) wobei der Hochtemperatursupraleiter (3) über mindestens eine 1. Hauptfläche flächenhaften Kontakt mit einer Hauptfläche eines Nebenschlußwiderstandes (1) hat und mit diesem einen Leiterverbund (1, 3) bildet,
dadurch gekennzeichnet,
d) daß mindestens eine Hauptfläche des Leiterverbundes (1, 3) mit einer mechanischen Stabilisierungsschicht (4, 4') in flächenhaftem Kontakt steht,
e) daß der Hochtemperatursupraleiter (3) eine Schichtdicke d3 von < 500 µm aufweist,
f) daß die Silberschicht (1) eine Schichtdicke dl von < 25 µm aufweist und
g) daß dl/d3 < 1/5 ist.

7. Strombegrenzer nach Anspruch 6, dadurch gekennzeichnet,
a) daß der Hochtemperatursupraleiter (3) eine Schichtdicke d3 von < 300 µm aufweist,
b) daß die Silberschicht (1) eine Schichtdicke dl von < 10 µm aufweist und
c) daß d1/d3 < 1/10 ist.

8. Strombegrenzer nach Anspruch 6 oder 7, dadurch gekennzeichnet,
a) daß die mechanische Stabilisierungsschicht (4, 4') eine Schichtdicke (d4, d4') im Bereich von 50 µm - 1 mm aufweist und
b) faserverstärkten Kunststoff enthält,
c) insbesondere, daß der faserverstärkte Kunststoff ein glas- oder kohlefaserverstärktes Epoxidharz ist.

9. Strombegrenzer nach einem der Ansprüche 6 bis 8, dadurch gekennzeichnet,
a) daß mindestens zwei mäanderförmig ausgebildete Strombegrenzerelemente (S1, S2) aus Leiterverbunden (1, 3) in der mechanischen Stabilisierungsschicht (4, 4') so gelagert sind, daß ein Strom (I) in einander gegenüberliegenden Bändern der Leiterverbunde (1, 3) antiparallel fließt,
b) insbesondere, daß zwischen je zwei derartigen Doppelmäandern (S1, S2) ein Kühlelement (7) eingebettet ist.

10. Strombegrenzer nach einem der Ansprüche 6 bis 9, dadurch gekennzeichnet, daß mindestens ein Leiterverbund (1, 3) mit einer mechanischen Stabilisierungsschicht (4, 4') zu einem Rohr gebogen ist und an einem Ringspalt (9) mit einem Metallstreifen (5) verschlossen ist.
